(19) Europäisches Patentamt / European Patent Office / Office européen des brevets

(11) **EP 4 472 393 A1**

(12) **EUROPEAN PATENT APPLICATION**
published in accordance with Art. 153(4) EPC

(43) Date of publication:
04.12.2024 Bulletin 2024/49

(51) International Patent Classification (IPC):
*H10N 50/10* (2023.01)

(21) Application number: 22923498.4

(22) Date of filing: 08.12.2022

(86) International application number:
PCT/CN2022/137478

(87) International publication number:
WO 2023/142708 (03.08.2023 Gazette 2023/31)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 28.01.2022 CN 202210106771

(71) Applicant: MultiDimension Technology Co., Ltd.
Jiangsu 215634 (CN)

(72) Inventors:
• DEAK, James Geza
Jiangsu 215634 (CN)
• ZHOU, Zhimin
Jiangsu 215634 (CN)

(74) Representative: HGF
HGF Limited
1 City Walk
Leeds LS11 9DX (GB)

(54) **MAGNETORESISTIVE SENSOR LAYER STRUCTURE FOR LASER ANNEALING**

(57) Disclosed in the embodiments of the present invention are a magnetoresistive sensor layer structure for laser annealing. The magnetoresistive sensor layer structure comprises a substrate; a magnetoresistive sensing unit, which is located on the substrate, comprises an antiferromagnetic pinned payer or a permanent magnet bias layer; A top heat absorption layer, which is located above the magnetoresistive sensing unit and/or a bottom heat absorption layer, which is located below the magnetoresistive sensing unit, wherein the product of the volume, specific heat and density of the top absorption layer is greater than the product of the volume, specific heat and density of a top electrode layer, the product of the volume, specific heat, and density of the bottom absorption layer is greater than the product of the volume, specific heat and density of a bottom electrode layer, and when a write temperature of the antiferromagnetic pinned layer or the permanent magnet bias layer is higher than a blocking temperature or Curie temperature respectively corresponding thereto, the temperature of the bottom electrode layer and the temperature of the top electrode layer are lower than melting point temperatures respectively corresponding thereto; and a laser absorption layer and a laser transparent layer. The embodiment of the present invention can solve the problem of an electrode layer being easily ablated.

**FIG. 1**

**Description**

**TECHNICAL FIELD**

The embodiments of the present invention relate to the technical field of magnetic sensor, in particular, to a layer structure of magnetoresistive sensor for laser annealing.

**BACKGROUND TECHNOLOGY**

Magnetoresistive sensors, such as magnetic tunnel junction sensors, can use an antiferromagnetic layer as the pinned layer. In this case, the method of magnetic-field annealing is used to obtain the magnetic field sensitive orientation of the magnetic tunnel junction under conditions higher than its blocking temperature. When a permanent magnetic bias layer is used in a magnetic tunnel junction to bias a reference layer or a free layer, magnetic-field annealing is performed under conditions higher than its Curie temperature to obtain the magnetization orientation of the permanent magnetic material.

When laser annealing is used, the laser scans the magnetoresistive sensing unit array on the grain of magnetoresistive sensor to obtain magnetoresistive sensing units with different sensitive orientations, thereby realizing the manufacturing of a multi-axis magnetoresistive sensor on a single grain. It is of great significance to the design, manufacturing and use of magnetoresistive sensors.

However, in the multi-layer structure of the magnetoresistive sensor, the overall structure of the bottom electrode layer/stacking layer of magnetic sensitive units/top electrode layer is very thin, almost at the nanometer level. Furthermore, there is a gap between adjacent magnetic tunnel junctions, and the gap is electrically connected only through the top electrode layer or the bottom electrode layer. Then, under the action at fixed laser power and fixed scanning speed, due to different heat capacity of the materials at the magnetic tunnel junction and the gap, the top electrode layer or bottom electrode layer at the gap may be heated to above the melting point of its material, causing ablation and blowing of the magnetoresistive sensor, when the antiferromagnetic pinned layer or permanent magnetic bias layer at the magnetic tunnel junction is heated to the critical blocking temperature or above Curie temperature.

**SUMMARY OF THE INVENTION**

The embodiments of the present invention provide a layer structure of magnetoresistive sensor for laser annealing, so as to solve the problem that the existing layer structure of magnetoresistive sensor is easily ablated during laser annealing.

The embodiments of the present invention provide a layer structure of magnetoresistive sensor for laser annealing, comprising:

A substrate;
A magnetoresistive sensing unit, which is located on the substrate, wherein the magnetoresistive sensing unit comprises a seed layer, a bottom electrode layer, a stacking layer of magnetic sensitive units and a top electrode layer in order from bottom to top, and the stacking layer of magnetic sensitive units comprises at least an antiferromagnetic pinned layer or a permanent magnetic bias layer;
A top heat absorption layer, which is located above the magnetoresistive sensing unit and/or a bottom heat absorption layer, which is located below the magnetoresistive sensing unit, wherein the product of the volume, specific heat and density of the top heat absorption layer is greater than the product of the volume, specific heat and density of the top electrode layer, the product of the volume, specific heat and density of the bottom heat absorption layer is greater than the product of the volume, specific heat and density of the bottom electrode layer, and when the write temperature of the antiferromagnetic pinned layer or the permanent magnetic bias layer is higher than a blocking temperature or Curie temperature respectively corresponding thereto, the temperature of the bottom electrode layer and the temperature of the top electrode layer are lower than the melting point temperatures respectively corresponding thereto.

A laser absorption layer, which is located above the magnetoresistive sensing unit;
A laser transparent layer, which is located above the laser absorption layer.

In the embodiments of the present invention, a heat absorption layer is provided on at least one of above and below the magnetoresistive sensing unit. The product of the volume, specific heat and density of the top heat absorption layer is greater than the product of the volume, specific heat and density of its adjacent top electrode layer, and the product of the volume, specific heat and density of the bottom heat absorption layer is greater than the product of the volume, specific heat and density of its adjacent bottom electrode layer. Then, the heat absorption layer has a much higher specific heat than the magnetoresistive sensing unit, which can maximize the uniformity of the specific heat of the film layer, the top electrode layer and the bottom electrode layer of the magnetoresistive sensing unit, and reduce the temperature rise difference caused by the difference in specific heat of the film layer, the top electrode layer and the bottom electrode layer of the magnetoresistive sensing unit. In this case, when the write temperature of the antiferromagnetic pinned layer/permanent magnetic bias layer reaches its blocking temperature/Curie temperature, the temperature rise of the bottom electrode layer and the top electrode layer is close, and the temperatures of the bottom electrode layer and the top electrode layer are both lower than their corresponding melting points. Based on this, ablation of the layer structure of magnetoresistive sensor during the laser annealing can be avoided, thereby improving the stability of the layer structure of magnetoresistive sensor and the laser annealing efficiency.

## DESCRIPTION OF THE DRAWINGS

In order to more clearly illustrate the technical solutions in the embodiments of the present invention or the prior art, the drawings required in the illustration of the embodiments or the prior art are briefly introduced below. Obviously, although the drawings described below are some specific embodiments of the present invention, for those skilled in the art, the drawings can be extended to other structures and drawings in accordance with the device structure disclosed and prompted by the various embodiments of the present invention, and the basic concepts of driving method and manufacturing method. There is no doubt that these should fall within the scope of the claims of the present invention.

FIG. 1 is a schematic diagram of the layer structure of a magnetoresistive sensor provided in the embodiments of the present invention;
FIG. 2 is a schematic diagram of the layer structure of another magnetoresistive sensor provided in the embodiments of the present invention;
FIG. 3 is a schematic diagram of the layer structure of a third magnetoresistive sensor provided in the embodiments of the present invention;
FIG. 4 is a topological diagram of the top heat absorption layer of the layer structure of magnetoresistive sensor;
FIG. 5 is a topological diagram of the top heat absorption layer of the layer structure of single-arm magnetoresistive sensor in FIG. 4;
FIG. 6 is a topological diagram of the top heat absorption layer of the layer structure of push-pull multi-arm magnetoresistive sensor in FIG. 4;
FIG. 7 is a topological diagram of the top heat absorption layer of the layer structure of another magnetoresistive sensor;
FIG. 8 is a topological diagram of the top heat absorption layer of the layer structure of single-arm magnetoresistive sensor in FIG. 7;
FIG. 9 is a topological diagram of the top heat absorption layer of the layer structure of push-pull multi-arm magnetoresistive sensor in FIG. 7;
FIG. 10 is a topological diagram of the top heat absorption layer of the layer structure of another magnetoresistive sensor;
FIG. 11 is a topological diagram of the top heat absorption layer of the layer structure of single-arm magnetoresistive sensor in FIG. 10;
FIG. 12 is a topological diagram of the top heat absorption layer of the layer structure of push-pull multi-arm magnetoresistive sensor in FIG. 10;
FIG. 13 is a topological diagram of the top heat absorption layer of the layer structure of another magnetoresistive sensor;
FIG. 14 is a topological diagram of the top heat absorption layer of the layer structure of single-arm magnetoresistive sensor in FIG. 13;
FIG. 15 is a topological diagram of the top heat absorption layer of the layer structure of push-pull multi-arm magnetoresistive sensor in FIG. 13;

## SPECIFIC IMPLEMENTATION METHODS

In order to make the purposes, technical solutions, and advantages of the present invention clearer, the technical solutions of the present invention will be clearly and completely described below through implementations with reference to the drawings in the embodiments of the present invention. Obviously, the described embodiments are some embodiments, rather than all the embodiments of the present invention. Based on the basic concepts disclosed and prompted by the embodiments of the present invention, all other embodiments obtained by those skilled in the art fall within the protection scope of the present invention.

The embodiments of the present invention provide a layer structure of magnetoresistive sensor for laser annealing. The layer structure of magnetoresistive sensor comprises a substrate; a magnetoresistive sensing unit located on the substrate, wherein the magnetoresistive sensing unit comprises a seed layer, a bottom electrode layer, a stacking layer of magnetic sensitive units and a top electrode layer in order from bottom to top, and the stacking layer of magnetic sensitive units comprises at least an antiferromagnetic pinned layer or a permanent magnetic bias layer; a top heat absorption layer located above the magnetoresistive sensing unit and/or a bottom heat absorption layer located below the magnetoresistive sensing unit, wherein the product of the volume, specific heat and density of the top heat absorption layer is greater than the product of the volume, specific heat and density of the top electrode layer, the product of the volume, specific heat and density of the bottom heat absorption layer is greater than the product of the volume, specific heat and density of the bottom electrode layer, and when the write temperature of the antiferromagnetic pinned layer or the permanent magnetic bias layer is higher than their corresponding blocking temperature or Curie temperature, the temperatures of the bottom electrode layer and the top electrode layer are both lower than their corresponding melting point; a laser absorption layer, wherein the laser absorption layer is located above the magnetoresistive sensing unit; and a laser transparent layer, wherein the laser transparent layer is located above the laser absorption layer.

In the embodiments of the present invention, a heat absorption layer is provided on at least one of above and below the magnetoresistive sensing unit. The product of the volume, specific heat and density of the top heat absorption layer is greater than the product of the volume, specific heat and density of its adjacent top electrode layer, and the product of the volume, specific heat and density of the bottom heat absorption layer is greater than the product of the volume, specific heat and density of its adjacent bottom electrode layer. Then, the heat absorption layer has a much higher specific heat than the magnetoresistive sensing unit, which can maximize the uniformity of the specific heat of the film layer, the top electrode layer and the bottom electrode layer of the magnetoresistive sensing unit, and reduce the temperature rise difference caused by the difference in specific heat of the film layer, the top electrode layer and the bottom electrode layer of the magnetoresistive sensing unit. In this case, when the write temperature of the antiferromagnetic pinned layer/permanent magnetic bias layer reaches its blocking temperature/Curie temperature, the temperature rise of the bottom electrode layer and the top electrode layer is close, and the temperatures of the bottom electrode layer and the top electrode layer are both lower than their corresponding melting points. Based on this, ablation of the layer structure of magnetoresistive sensor during the laser annealing can be avoided, thereby improving the stability of the layer structure of magnetoresistive sensor and the laser annealing efficiency.

The optional substrate has a passivation layer on its surface facing the magnetoresistive sensing unit, and the thermal conductivity of the passivation layer is less than 1/10 of the thermal conductivity of the seed layer.

The material of the optional top heat absorption layer or the bottom heat absorption layer can be tantalum, titanium, copper, molybdenum, gold, silver, aluminum, platinum or tin.

The material of the optional laser absorption layer is carbon black, or a non-magnetic laser absorption resin containing carbon black, or a laser absorption paint.

The material of the optional laser transparent layer may be $ZrO_2$, TisOs, $Ta_2O_5$, $HfO_2$, ZnS, ZnSe, $Al_2O_3$, MgO, $MgF_2$, $SiO_2$, $YbF_3$ or $AlF_3$.

The thickness of the optional top heat absorption layer or bottom heat absorption layer is determined by the power of the external laser annealing and the heating time.

Optionally, in a bottom-up direction,

The top heat absorption layer covers the top electrode layer and the bottom electrode layer, and the top heat absorption layer is electrically isolated from the top electrode layer;

The top heat absorption layer comprises a first region and a second region. The first region overlaps with the bottom electrode layer and does not overlap with the top electrode layer. The second region overlaps with the top electrode layer. An insulating material is filled between the top heat absorption layer and the top electrode layer. The first region and the second region are in electrical contact.

Optionally, the top heat absorption layer also comprises a third region. The third region does not overlap with the top electrode layer and the bottom electrode layer, and is in electrical contact with the first region and the second region, respectively.

Optionally, in a bottom-up direction,

The top heat absorption layer covers the top electrode layer and the bottom electrode layer, and the top heat absorption layer is in electrical contact with the top electrode layer;

The top heat absorption layer comprises a first region and a second region. The first region overlaps with the bottom electrode layer and does not overlap with the top electrode layer. The second region overlaps with the top electrode layer. The first region is electrically isolated from the second region.

Optionally, the top heat absorption layer also comprises a third region. The third region does not overlap with the top electrode layer and the bottom electrode layer, and is electrically isolated from the first region and the second region, respectively.

Optionally, in a bottom-up direction,

The bottom heat absorption layer covers the top electrode layer and the bottom electrode layer, and the bottom heat absorption layer is electrically isolated from the bottom electrode layer;
The bottom heat absorption layer comprises a fourth region and a fifth region. The fourth region overlaps with the bottom electrode layer and does not overlap with the top electrode layer. The fifth region overlaps with the bottom electrode layer. An insulating material is filled between the bottom heat absorption layer and the bottom electrode layer. The fourth region and the fifth region are in electrical contact.

Optionally, the bottom heat absorption layer also comprises a sixth region. The sixth region does not overlap with the top electrode layer and the bottom electrode layer, and is in electrical contact with the fourth region and the fifth region, respectively.

Optionally, in a bottom-up direction,
The bottom heat absorption layer covers the top electrode layer and the bottom electrode layer. The bottom heat absorption layer and the bottom electrode layer are in electrical contact.

The bottom heat absorption layer comprises a fourth region and a fifth region. The fourth region overlaps with the bottom electrode layer and does not overlap with the top electrode layer. The fifth region overlaps with the bottom electrode layer. The fourth region is electrically isolated from the fifth region.

Optionally, the bottom heat absorption layer also comprises a sixth region. The sixth region does not overlap with the top electrode layer and the bottom electrode layer, and is electrically isolated from the fourth region and the fifth region, respectively.

It should be noted that the above description that the heat absorption layer covers the electrode layer in the bottom-up direction actually means that the projection of the heat absorption layer in the bottom-up direction covers the projection of the electrode layer in the bottom-up direction. The details will not be described below.

The above are the main solutions provided by the embodiments of the present invention. The layer structure of magnetoresistive sensor provided by the embodiments of the present invention will be described in detail with reference to the accompanying drawings and through specific embodiments.

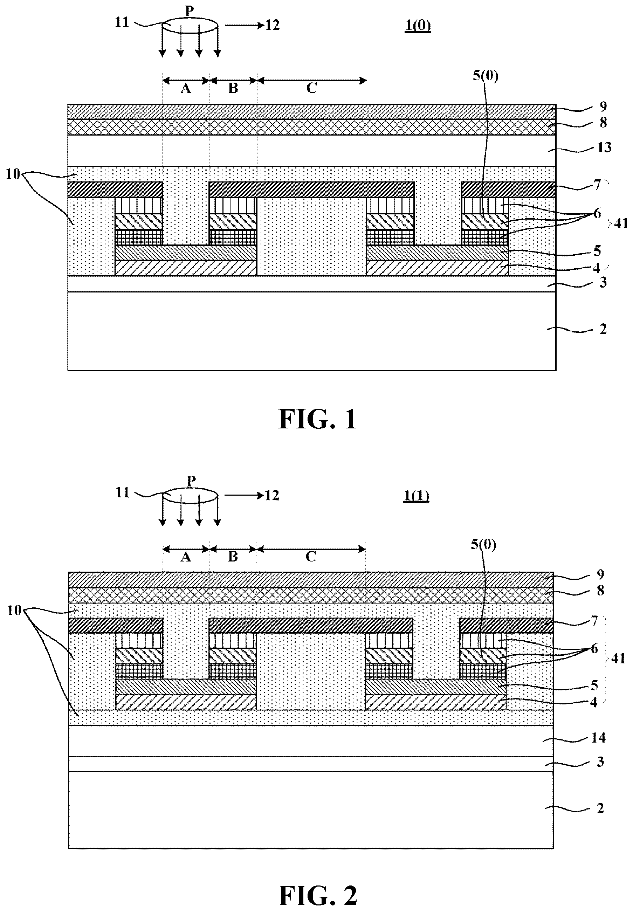

FIG. 1 shows a schematic diagram of the layer structure of a magnetoresistive sensor provided in the embodiments of the present invention. As shown in FIG. 1, the layer structure 1(0) of magnetoresistive sensor comprises a top heat absorption layer 13 located above the top electrode layer 7. Specifically, the layer structure 1(0) of magnetoresistive sensor comprises at least a substrate 2, a passivation layer 3, a magnetoresistive sensing unit 41, a top heat absorption layer 13, a laser absorption layer 8 and a laser transparent layer 9 from bottom to top. Among them, the magnetoresistive sensing unit 41 comprises a seed layer 4, a bottom electrode layer 5, a stacking layer 6 of magnetic sensitive units and a top electrode layer 7 from bottom to top. The stacking layer 6 of magnetic sensitive units comprises at least an antiferromagnetic pinned layer or a permanent magnetic bias layer 5 (0).

The optional substrate 2 is typically a silicon wafer, but is not limited thereto. The optional passivation layer 3 is a low thermal conductivity insulating layer, which prevents heat conduction from above to the substrate 2. Then the thermal conductivity of the passivation layer 3 can be 1/10 of the thermal conductivity of the seed layer 4, which is not limited to while ensuring the stability of the layer structure of magnetoresistive sensor.

The magnetoresistive sensing unit 41 in the layer structure 1(0) of magnetoresistive sensor is interconnected via the bottom electrode layer 5 and the top electrode layer 7. Insulating material 10 is filled between the layers of the magnetoresistive sensing unit 41 in the layer structure 1(0) of magnetoresistive sensor, and can be used for insulation between the layers of the magnetoresistive sensing unit 41. Insulating material 10 is filled between the magnetoresistive sensing unit 41 and the top heat absorption layer 13 in the layer structure 1(0) of magnetoresistive sensor to achieve electrical isolation.

The layer structure 1(0) of magnetoresistive sensor is annealed by using laser, where the scanning direction 12 of the laser spot 11 on the surface of the layer structure 1(0) of magnetoresistive sensor is horizontal.

FIG. 2 shows a schematic diagram of the layer structure of another magnetoresistive sensor provided in the embodiments of the present invention. As shown in FIG. 2, the layer structure 1(1) of magnetoresistive sensor comprises a bottom heat absorption layer 14 located below the bottom electrode layer 5. Specifically, the layer structure 1(1) of magnetoresistive sensor comprises at least a substrate 2, a passivation layer 3, a bottom heat absorption layer 14, a magnetoresistive sensing unit 41, a laser absorption layer 8 and a laser transparent layer 9 from bottom to top. The same parts in FIG. 2 as in FIG. 1 will not be described again.

Insulating material 10 is filled between the magnetoresistive sensing unit 41 and the bottom heat absorption layer 14 in the layer structure 1(1) of magnetoresistive sensor to achieve electrical isolation.

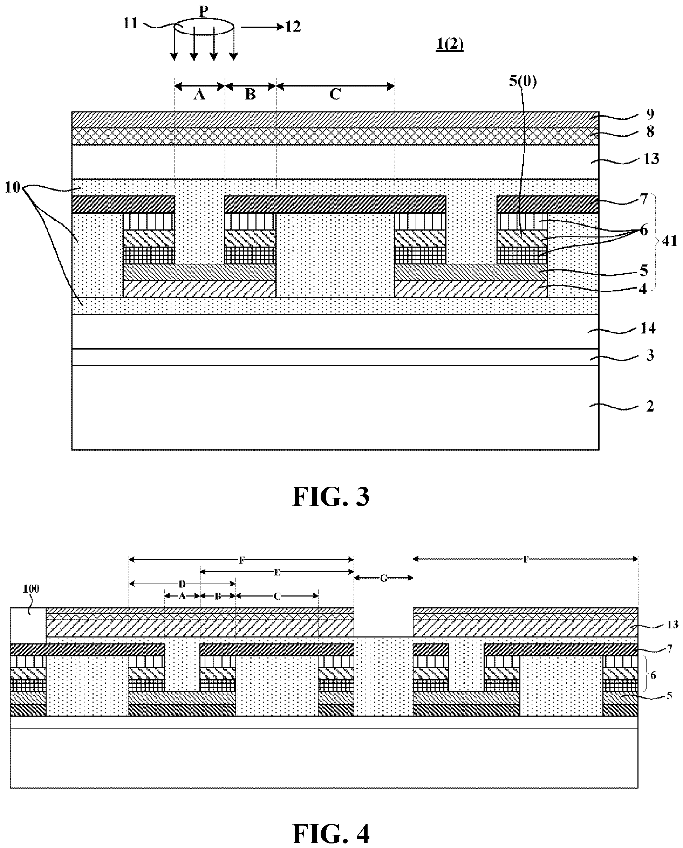

FIG. 3 shows a schematic diagram of the layer structure of another magnetoresistive sensor in the embodiments of the present invention. As shown in FIG. 3, the layer structure 1(2) of magnetoresistive sensor comprises a bottom heat absorption layer 14 located below the bottom electrode layer 5 and a top heat absorption layer 13 located above the top electrode layer 7. Specifically, the layer structure 1(2) of magnetoresistive sensor comprises at least a substrate 2, a passivation layer 3, a bottom heat absorption layer 14, a magnetoresistive sensing unit 41, a top heat absorption layer 13, a laser absorption layer 8 and a laser transparent layer 9 from bottom to top. The same parts in FIG. 3 as in FIG. 1 will not be described again.

Insulating material 10 is filled between the magnetoresistive sensing unit 41 and the top heat absorption layer 13 in the layer structure 1(2) of magnetoresistive sensor to achieve electrical isolation. Insulating material 10 is filled between the magnetoresistive sensing unit 41 and the bottom heat absorption layer 14 in the layer structure 1(2) of magnetoresistive sensor to achieve electrical isolation.

It can be seen that, in the layer structure of magnetoresistive sensor in FIG. 1, the layer structure 1(0) of magnetoresistive sensor has three regions with different material structures, namely, Region A, Region B and Region C. Among them, the material structure of Region A is: laser transparent layer 9/laser absorption layer 8/top heat absorption layer 13/insulating material 10/bottom electrode layer 5/seed layer 4. The material structure of Region B is: laser transparent layer 9/laser absorption layer 8/top heat absorption layer 13/insulating material 10/top electrode layer 7/stacking layer 6 of magnetic sensitive units/bottom electrode layer 5/seed layer 4. The material structure of Region C is: laser transparent layer 9/laser absorption layer 8/top heat absorption layer 13/insulating material 10/top electrode layer 7/insulating material 10.

In the layer structure of magnetoresistive sensor in FIG. 2, the layer structure 1(1) of magnetoresistive sensor has three regions with different material structures, namely, Region A, Region B and Region C. Among them, the material structure of Region A is: laser transparent layer 9/laser absorption layer 8/insulating material 10/bottom electrode layer 5/seed layer 4/insulating material 10/bottom heat absorption layer 14. The material structure of Region B is: laser transparent layer 9/laser absorption layer 8/insulating material 10/top electrode layer 7/stacking layer 6 of magnetic sensitive units/bottom electrode layer 5/seed layer 4/insulating material 10/bottom heat absorption layer 14. The material structure of area C is: laser transparent layer 9/laser absorption layer 8/insulating material 10/top electrode layer 7/insulating material 10/bottom heat absorption layer 14.

In the layer structure of magnetoresistive sensor in FIG. 3, the layer structure 1(2) of magnetoresistive sensor has three regions with different material structures, namely, Region A, Region B and Region C. Among them, the material structure of Region A is: laser transparent layer 9/laser absorption layer 8/top heat absorption layer 13/insulating material 10/bottom electrode layer 5/seed layer 4/insulating material 10/bottom heat absorption layer 14. The material structure of Region B is: laser transparent layer 9/laser absorption layer 8/top heat absorption layer 13/insulating material 10/top electrode layer 7/stacking layer 6 of magnetic sensitive units/bottom electrode layer 5/seed layer 4/insulating material 10/bottom heat absorption layer 14. The material structure of Region C is: laser transparent layer 9/laser absorption layer 8/top heat absorption layer 13/insulating material 10/top electrode layer 7/insulating material 10/bottom heat absorption layer 14.

During the laser annealing stage, the laser will instantaneously heat up, causing heat to transfer from the upper surface of the layer structure of magnetoresistive sensor to its lower surface.

If there is no heat absorption layer, the different material structures in Region A, Region B and Region C lead to different products of volume, specific heat and density products in different regions of the layer structure of magnetoresistive sensor, and different heat transfer efficiency and temperature rise effects, thus making the temperatures in Region A and Region C higher than the melting points of the bottom electrode layer 5 and the top electrode layer 7, and causing damage to Region A and Region C.

In the embodiments of the present invention, a bottom heat absorption layer 14 and/or a top heat absorption layer 13 are added. The product of the volume, specific heat and density of the top heat absorption layer 13 is greater than the product of the volume, specific heat and density of the corresponding top electrode layer 7, and the product of the volume, specific heat and density of the bottom heat absorption layer 14 is greater than the product of the volume, specific heat and density of the corresponding bottom electrode layer 5. Assuming that the stacking layer 6 of magnetic sensitive units comprises an antiferromagnetic pinned layer 5(0), when the write temperature of the antiferromagnetic pinned layer 5(0) is higher than its blocking temperature, the temperature of the bottom electrode layer 5 is lower than its melting point, and the temperature of the top electrode layer 7 is lower than its melting point. Alternatively, assuming that the stacking layer 6 of magnetic sensitive units comprises a permanent magnetic bias layer 5(0), when the write temperature of the permanent magnetic bias layer 5(0) is higher than its Curie temperature, the temperature of the bottom electrode layer 5 is lower than its melting point, and the temperature of the top electrode layer 7 is lower than its melting point, thus avoiding damage to the layer structure of magnetoresistive sensor.

The following statements are based on specific principles and formulas.

Using a simple one-dimensional heat conduction model, the temperature rise of the material is expressed as Formula (1):

$$\Delta T = \frac{P \cdot t}{m \cdot C_v} \qquad\qquad (1),$$

Wherein, $\Delta T$ is the temperature rise (unit: °C), P the laser power (unit: W), t the heating time (unit: s), m the material mass (unit: kg), and Cv the specific heat of the material (unit: J/kg • °C).

For the case where Region A and Region C have a single material, the calculation is as follows:

The material mass m is expressed as Formula (2):

$$m = \rho \bullet V \qquad (2),$$

Wherein, $\rho$ is the density (unit: kg/m$^3$), and v is the heating volume (unit: m$^3$);
The heating volume v is expressed as formula (3):

$$v = W \bullet h \bullet d \qquad (3),$$

Wherein, W is the width of Region A, Region B or Region C, h is the thickness of Region A, Region B or Region C, and d is the diameter of the laser spot.

For the case where multiple materials are introduced into Region A, Region B and Region C, the calculation is as follows:

The total heating volume V is expressed as Formula (4):

$$V = \sum_i V_i \qquad (4);$$

The total material mass M is expressed as Formula (5):

$$M = \sum_i \rho_i \bullet V_i \qquad (5);$$

The density $\rho$ is expressed as Formula (6):

$$\rho = \frac{M}{V} \qquad (6);$$

The average material specific heat $\overline{C_v}$ is expressed as Formula (7):

$$\overline{C_V} = \frac{\sum_i C_{Vi} \bullet V_i}{\sum_i V_i}; \qquad (7).$$

When no heat absorption layer is provided in layer structure of the magnetoresistive sensor, the material characteristics and temperature rise results of the Region A, Region B and Region C are described in the following Tables 1 to 4.

Table 1 shows the material characteristics and temperature rise results of Region A, Region B and Region C.

Table 1

| | Region A | Region C | Region B Composite |
|---|---|---|---|
| Blocking temperature Tb (°C) | 350 | | |
| Laser power P (W) | 5 | | |
| Laser diameter d (um) | 25 | | |
| Retention time t (us) | 0.1 | | |
| | Region A | Region C | Region B Composite |
| Thickness h (um) | 0.150 | 1 | 0.50 |
| Width W (um) | 15 | 10 | 5 |

(continued)

|  | Region A | Region C | Region B Composite |
|---|---|---|---|
| Heating volume V (um$^3$) | 56.3 | 250 | 369 |
| Material | Ta | Cu | Main NiFe |
| Density (g/cc) | 16.6 | 8.92 | 10.05 |
| Specific heat (J/g*K) | 0.138 | 0.38 | 0.36 |
| Mass (ng) | 9.34 | 2.23 | 3.71 |
| Temperature change dT (°C) | 3,880.26 | 590.04 | 371.09 |
| Actual temperature T (°C) | 3,903.26 | 613.04 | 394.09 |
| Melting point (°C) | 3,017 | 1,084 | 1,527 |

As shown in Table 1 above, it is assumed that the laser annealing conditions are: blocking temperature Tb=350°C, laser power P is 5W, laser spot diameter d is 25um, and heating time t, i.e., retention time, is 0.1us.

Assume that the dimensions of each layer in the magnetoresistive sensing unit are:

Seed layer/bottom electrode layer (Ta): thickness 0.15um, width 15um;
Top electrode layer (Cu): thickness 1.00um, width 10um;
Stacking layer of magnetic sensitive units (mainly NiFe): thickness 0.50um, width 5um.

For the magnetoresistive sensing unit composed of seed layer/bottom electrode layer/stacking layer of magnetic sensitive units/top electrode layer, the materials in different regions are: the material of magnetoresistive sensing unit in Region A is mainly Ta. The material of magnetoresistive sensing unit in Region C is mainly Cu, and the material of magnetoresistive sensing unit in Region B is mainly a composite material Ta/main NiFe/Cu.

It can be seen from Table 1 that, during the laser annealing stage, when the temperature of the composite material Ta/main NiFe/Cu in Region B reaches 394°C, it approaches the blocking temperature Tb=350°C of the antiferromagnetic pinned layer. At this point, the temperature in Region A reaches 3,903°C, which exceeds 3,017°C, the melting point of the bottom electrode layer Ta, and the temperature in Region C reaches 613°C, which is lower than 1,084°C, the melting point of Cu. Obviously, ablation will occur in Region A, causing the entire layer structure of magnetoresistive sensor to malfunction.

In order to reduce the temperature of Region A, the thickness of the seed layer/bottom electrode layer is increased to 200 nm. Table 2 shows material characteristics and temperature rise results of another type of Region A, Region B and Region C.

Table 2

| Blocking temperature Tb (°C) | 350 | | |
|---|---|---|---|
| Laser power P (W) | 5 | | |
| Laser diameter d (um) | 25 | | |
| Retention time t (us) | 0.1 | | |
|  | Region A | Region C | Region B Composite |
| Thickness h (um) | 0.20 | 1.0 | 0.5 |
| Width W (um) | 15 | 10 | 5 |
| Heating volume V (um$^3$) | 75.0 | 250 | 388 |
| Material | Ta | Cu | Main NiFe |
| Density (g/cc) | 16.6 | 8.92 | 10.37 |
| Specific heat (J/g*K) | 0.138 | 0.38 | 0.35 |
| Mass (ng) | 1.25 | 2.23 | 4.02 |
| Temperature change dT (°C) | 2,910.19 | 590.04 | 352.94 |
| Actual temperature T (°C) | 2,933.19 | 613.04 | 375.94 |

(continued)

|  | Region A | Region C | Region B Composite |
|---|---|---|---|
| Melting point (°C) | 3,017 | 1,084 | 1,527 |

As shown in Table 2 above, assume that the dimensions of each layer in the magnetoresistive sensing unit are:

Seed layer/bottom electrode layer (Ta): thickness 0.20um, width 15um;
Top electrode layer (Cu): thickness 1.00um, width 10um;
Stacking layer of magnetic sensitive units (mainly NiFe): thickness 0.50um, width 5um.

It can be seen from Table 2 that, during the laser annealing stage, when the temperature of the composite material Ta/main NiFe/Cu in Region B reaches 375°C, it approaches the blocking temperature Tb=350°C of the antiferromagnetic pinned layer. At this point, the temperature in Region A reaches 2,933°C, which is lower than 3,017°C, the melting point of Ta, and the temperature in Region C reaches 613°C, which is lower than 1,084°C, the melting point of Cu. Although ablation will not occur in Region A, its temperature is still close to the melting point of the bottom electrode layer Ta, making it prone to ablation.

By further increasing the thickness of the seed layer/bottom electrode layer to 250 nm, Table 3 shows the material characteristics and temperature rise results of another type of Region A, Region B and Region C.

Table 3

| Blocking temperature Tb (°C) | 350 | | |
|---|---|---|---|
| Laser power P (W) | 5 | | |
| Laser diameter d (um) | 25 | | |
| Retention time t (us) | 0.1 | | |
|  | Region A | Region C | Region B Composite |
| Thickness h (um) | 0.25 | 1.0 | 0.5 |
| Width W (um) | 15 | 10 | 5 |
| Heating volume V (um$^3$) | 93.8 | 250 | 406 |
| Material | Ta | Cu | Main NiFe |
| Density (g/cc) | 16.6 | 8.92 | 10.66 |
| Specific heat (J/g*K) | 0.138 | 0.38 | 0.34 |
| Mass (ng) | 1.56 | 2.23 | 4.33 |
| Temperature change dT (°C) | 2,328.15 | 590.04 | 337.04 |
| Actual temperature T (°C) | 2,351.15 | 613.04 | 360.04 |
| Melting point (°C) | 3,017 | 1,084 | 1,527 |

As shown in Table 3 above, assume that the dimensions of each layer in the magnetoresistive sensing unit are:

Seed layer/bottom electrode layer (Ta): thickness 0.25um, width 15um;
Top electrode layer (Cu): thickness 1.00um, width 10um;
Stacking layer of magnetic sensitive units (mainly NiFe): thickness 0.50um, width 5um.

It can be seen from Table 3 that, during the laser annealing stage, when the temperature of the composite material Ta/main NiFe/Cu in Region B reaches 360°C, it approaches the blocking temperature Tb=350°C of the antiferromagnetic pinned layer. At this point, the temperature in Region A reaches 2,351°C, which is further lower than 3,017°C, the melting point of Ta, and the temperature in Region C reaches 613°C, which is lower than 1,084°C, the melting point of Cu. Although ablation will not occur in Region A, the temperature difference between Region A/B/C is still very large.

By increasing the thickness of the top electrode layer to 1.1um, Table 4 shows the material characteristics and temperature rise results of another type of Region A, Region B and Region C.

Table 4

| | Region A | Region C | Region B Composite |
|---|---|---|---|
| Blocking temperature Tb (°C) | 350 | | |
| Laser power P (W) | 5 | | |
| Laser diameter d (um) | 25 | | |
| Retention time t (us) | 0.1 | | |
| | Region A | Region C | Region B Composite |
| Thickness h (um) | 0.25 | 1.1 | 0.5 |
| Width W (um) | 15 | 10 | 5 |
| Heating volume V (um$^3$) | 93.8 | 275 | 431 |
| Material | Ta | Cu | Main NiFe |
| Density (g/cc) | 16.6 | 8.92 | 10.56 |
| Specific heat (J/g*K) | 0.138 | 0.38 | 0.34 |
| Mass (ng) | 1.56 | 2.45 | 4.55 |
| Temperature change dT (°C) | 2,328.15 | 536.40 | 318.51 |
| Actual temperature T (°C) | 2,351.15 | 559.40 | 341.51 |
| Melting point (°C) | 3,017 | 1,084 | 1,527 |

As shown in Table 4 above, assume that the dimensions of each layer in the magnetoresistive sensing unit are:

Seed layer/bottom electrode layer (Ta): thickness 0.25um, width 15um;
Top electrode layer (Cu): thickness 1.10um, width 10um;
Stacking layer of magnetic sensitive units (mainly NiFe): thickness 0.50um, width 5um.

It can be seen from Table 4 that, during the laser annealing stage, when the temperature of the composite material Ta/main NiFe/Cu in Region B reaches 341°C, it is lower than the blocking temperature Tb=350°C of the antiferromagnetic pinned layer. At this point, the temperature in Region A reaches 2,351°C, which is lower than 3,017°C, the melting point of Ta, and the temperature in Region C reaches 559°C, which is lower than 1,084°C, the melting point of Cu. However, the composite material in Region B cannot reach the blocking temperature and cannot complete the laser writing operation of the magnetoresistive sensing unit.

It can be seen from Tables 1 to 4 above that the efficiency of simply increasing the film thickness of the magnetoresistive sensor unit is very low.

Based on this, a heat absorption layer is added to the layer structure of magnetoresistive sensor, and the material characteristics and temperature rise results of Region A, Region B and Region C are described in Table 5 below.

Table 5

| | Region A | Region C | Region B Composite |
|---|---|---|---|
| Blocking temperature Tb (°C) | 350 | | |
| Laser power P (W) | 20 | | |
| Laser diameter d (um) | 25 | | |
| Retention time t (us) | 0.1 | | |
| | Region A | Region C | Region B Composite |
| Thermally conductive materials | Cu | Cu | Cu |
| Specific heat (J/g*K) | 0.38 | 0.38 | 0.38 |
| Density (g/cc) | 8.92 | 8.92 | 8.92 |
| Thickness h (um) | 2 | 2 | 2 |
| Volume V (um$^3$) | 982 | 982 | 982 |
| Specific heat*density*volume (J/K*10^-12) | 3,328 | 3,328 | 3,328 |

(continued)

| | Region A | Region C | Region B Composite |
|---|---|---|---|
| Thickness h (um) | 0.25 | 1.1 | |
| Width W (um) | 15 | 10 | |
| Heating volume V (um$^3$) | 93.8 | 275 | 431 |
| Material | Ta | Cu | Main NiFe |
| Density (g/cc) | 16.6 | 8.92 | 10.56 |
| Specific heat (J/g*K) | 0.138 | 0.38 | 0.34 |
| Specific heat*density*volume (J/K*10$^{-12}$) | 214 | 932 | 1,547 |
| Mass (ng) | 1.56 | 2.45 | 4.55 |
| Equivalent specific heat (J/g*K) | 3.59E-01 | 3.80E-01 | 3.69E-01 |
| Equivalent density (g/cc) | 9.59 | 8.92 | 9.42 |
| Equivalent mass (ng) | 10.3 | 11.2 | 13.3 |
| Temperature change dT (°C) | 540.31 | 469.50 | 406.93 |
| Actual temperature T (°C) | 563.31 | 492.50 | 429.93 |
| Melting point (°C) | 3,017 | 1,084 | 1,527 |

As shown in Table 5, for example, add a top heat absorption layer in Region A, B and C, and the material of the top heat absorption layer is Cu with a thickness of 2 um.

It can be seen that when the temperature of the composite material in Region B reaches 429°C, the laser power increases to 20W. However, the temperature in Region A drops to 563°C, and the temperature of Region C decreases to 492°C. The temperatures of the entire A, B, and C regions are very close, far below the melting points of the top and bottom electrode layers. Although the laser power will increase to 20W, the increase in laser power can be achieved by simply adjusting the laser parameters.

Based on this, a heat absorption layer is introduced, and the product of specific heat, density and volume of the heat absorption layer is 3,328, which is much larger than 214 of the bottom electrode layer, 932 of the top electrode layer, and 1,547 of the stacking layer of magnetic sensitive units. It can make the temperatures of Region A, Region B, and Region C very close, far lower than the melting points of the top electrode layer and the bottom electrode layer.

The following describes that the heat absorption layer in the layer structure of magnetoresistive sensor is mainly divided into two cases.

In the first case, the heat absorption layer is electrically isolated from the adjacent electrode layer by an insulating layer, which is very thin for easy heat conduction. In this case, the arrangement of the heat absorption layer is not affected by the arrangement of the electrode layer. Specifically, the top heat absorption layer is electrically isolated from the top electrode layer; and/or the bottom heat absorption layer is electrically isolated from the bottom electrode layer.

In the second case, the heat absorption layer is in direct electrical contact with the adjacent electrode layer. Necessary electrical isolation must be provided between the corresponding different regions of heat absorption layer in the layer structure of magnetoresistive sensor to prevent adjacent magnetoresistive sensing units from short circuiting due to the conduction connection of the heat absorption layer. The advantage of this case is that the heat absorption layer directly transfers heat to the electrode layer. Specifically, the top heat absorption layer is in electrical contact with the top electrode layer, and electrical isolation must be provided between the corresponding different regions of top heat absorption layer in the layer structure of magnetoresistive sensor. And/or, the bottom heat absorption layer is in electrical contact with the bottom electrode layer, and electrical isolation must be provided between corresponding different regions of bottom heat absorption layer in the layer structure of magnetoresistive sensor.

For the convenience of description, the following embodiments only illustrate the design of the top heat absorption layer in the layer structure of magnetoresistive sensor, and the design principle is also applicable to the design of the bottom heat absorption layer in the layer structure of magnetoresistive sensor. It can be understood that the design principle of the first region of the top heat absorption layer is the same as that of the fourth region of the bottom heat absorption layer. The design principle of the second region of the top heat absorption layer is the same as that of the fifth area of the bottom heat absorption layer. The design principle of the third region of the top heat absorption layer is the same as that of the sixth region of the bottom heat absorption layer.

For the case where insulating material is used for electrical isolation between the top heat absorption layer and the top electrode layer, the topological structure is shown below.

FIG. 4 is a topological diagram of the top heat absorption layer of the layer structure of magnetoresistive sensor. The top heat absorption layers 13 in the layer structure of two adjacent magnetoresistive sensors are electrically isolated from each other. In other embodiments, the top heat absorption layers in the layer structure of two adjacent magnetoresistive sensor may, optionally, be directly connected to each other. The layer structure of magnetoresistive sensor comprises a pin 100 which is not covered by the top heat absorption layer 13. As shown in FIG. 4, in the bottom-up direction, the top heat absorption layer 13 covers the top electrode layer 7 and the bottom electrode layer 5, and is electrically isolated from the top electrode layer 7. The top heat absorption layer 13 comprises a first region and a second region. The first region overlaps with the bottom electrode layer 5 and does not overlap with the top electrode layer 7. The second region overlaps with the top electrode layer 7. An insulating material is filled between the top heat absorption layer 13 and the top electrode layer 7. The first region and the second region are in electrical contact.

Wherein, the first region of the top heat absorption layer 13 corresponds to Region A of the layer structure of magnetoresistive sensor, and the second region of the top heat absorption layer 13 corresponds to Region E of the layer structure of magnetoresistive sensor. Region E comprises Region B and Region C.

The top heat absorption layer 13 will be described in detail by defining Region D and Region F in the layer structure of magnetoresistive sensor. The top heat absorption layer region covered above the bottom electrode layer 5 is Region D of the layer structure of magnetoresistive sensor that corresponds to the top heat absorption layer 13. The top heat absorption layer region covered above the top electrode layer 7 is Region E of the layer structure of magnetoresistive sensor that corresponds to the top heat absorption layer 13. The union Region F formed by Region D and Region E of the layer structure of magnetoresistive sensor constitutes a topological structure corresponding to the top heat absorption layer 13. The Region G is the corresponding region not covered by the top heat absorption layer 13, the top electrode layer 7 and the bottom electrode layer 5.

During the laser scanning of the topological structure corresponding to FIG. 4, although there may be a difference in heat conduction between Region G not covered by the top heat absorption layer 13 and Region F covered by the laser, it does not affect the magnetic-field annealing of the array area of the magnetoresistive sensing unit by laser.

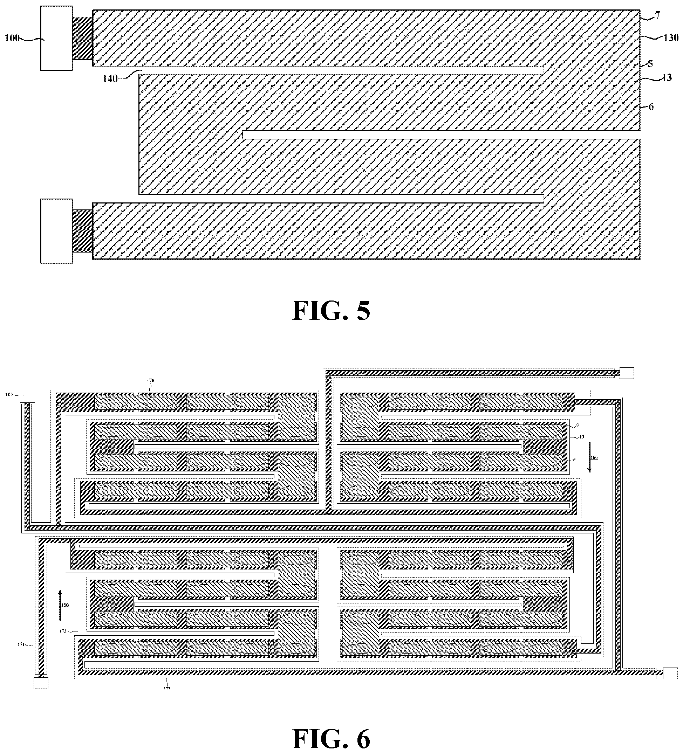

FIG. 5 is a topological diagram of the top heat absorption layer of the single-arm magnetoresistive sensor layer structure in FIG. 4. In the magnetoresistive sensor layer structure, the topological structure of the top heat absorption layer formed by the union of all D regions and E regions of the magnetoresistive sensor layer structure is shown as mark 130. The topological structure of all G regions is shown as mark 140, and 140 is not covered by the top heat absorption layer 13, the top electrode layer 7 and the bottom electrode layer 5. The elliptical shape represents the magnet sensitive unit stacking layer 6.

FIG. 6 is a topological diagram of the top heat absorption layer of the push-pull multi-arm magnetoresistive sensor layer structure in FIG. 4. 100 is a pin. The two magnetoresistive sensing unit arms on the left have an antiferromagnetic pinned layer magnetizing orientation 150, and the two magnetoresistive sensing unit arms on the right have an antiferromagnetic pinned layer magnetizing orientation 160, wherein the magnetizing orientation 150 is opposite to the magnetizing orientation 160. The union of the top heat absorption layer region above the top electrode layer 7 and the top heat absorption layer region above the bottom electrode layer 5 in the magnetoresistive sensing unit array is marked as 170. The top heat absorption layer connection region between the magnetoresistive sensing unit arrays is marked as 172. The top heat absorption layer region of the connecting pin 100 is marked as 171. 173 is the region not covered by the top electrode layer 7, the bottom electrode layer 5 and the top heat absorption layer 13.

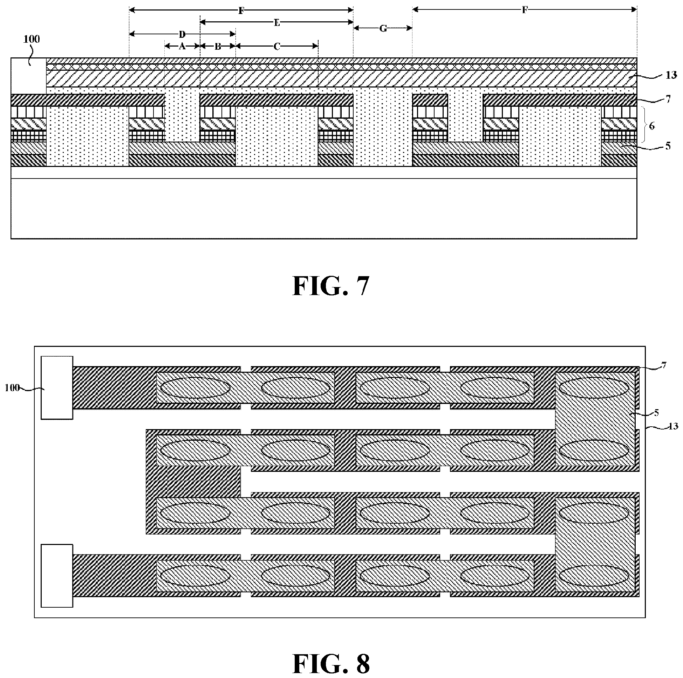

FIG. 7 is a topological diagram of the top heat absorption layer of another magnetoresistive sensor layer structure. The top heat absorption layers 13 of two adjacent magnetoresistive sensor layer structures are directly connected. As is shown in FIG. 7, the top heat absorption layer 13 also comprises a third region. The third region does not overlap with the top electrode layer 7 and the bottom electrode layer 5, and the third region is in electrical contact with the first region and the second region, respectively. 100 is a pin, the upper part of which is not covered by the top heat absorption layer 13. Region E of the magnetoresistive sensor layer structure above the top electrode layer 7 corresponds to the second region of the top heat absorption layer 13. Region A of the magnetoresistive sensor layer structure above the bottom electrode layer 5 corresponds to the first region of the top heat absorption layer 13. Region G not covered by the electrode layer corresponds to the third region of the top heat absorption layer 13.

FIG. 8 is a topological diagram of the top heat absorption layer of the single-arm magnetoresistive sensor layer structure in FIG. 7. In the magnetoresistive sensor layer structure, the region except the pin 100 is covered by the top heat absorption layer 13.

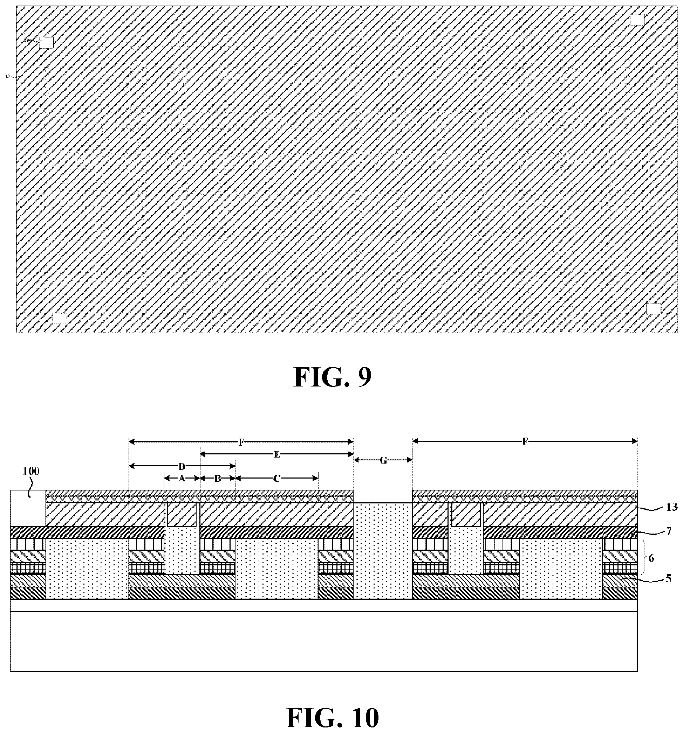

FIG. 9 is a topological diagram of the top heat absorption layer of the push-pull multi-arm magnetoresistive sensor layer structure in FIG. 7. 100 is a pin, and the region except the pin 100 is covered by the top heat absorption layer 13.

FIG. 10 is a topological diagram of the top heat absorption layer of another magnetoresistive sensor layer structure. In the magnetoresistive sensor layer structure, the top heat absorption layer 13 covers the top electrode layer 7 and the bottom electrode layer 6 from bottom to top, and the top heat absorption layer 13 is in electrical contact with the top electrode layer 7, which can reduce the thermal conduction barrier.

In order to avoid short circuit between the magnetoresistive sensing units 6, the top heat absorption layer 13 comprises a first region and a second region, with the first region overlapping with the bottom electrode layer 5 and not overlapping with the top electrode layer 7, the second region overlapping with the top electrode layer 7, a gap between the top heat absorption layers in the first region and the second region, the first region and the second region being electrically isolated from each other, and the top heat absorption layer above the Region A and the top heat absorption layer above the Region B being electrically isolated from each other. In addition, the pin 100 is not covered by the top heat absorption layer 13, and the Region G of the magnetoresistive sensor layer structure is not covered by the top heat absorption layer 13.

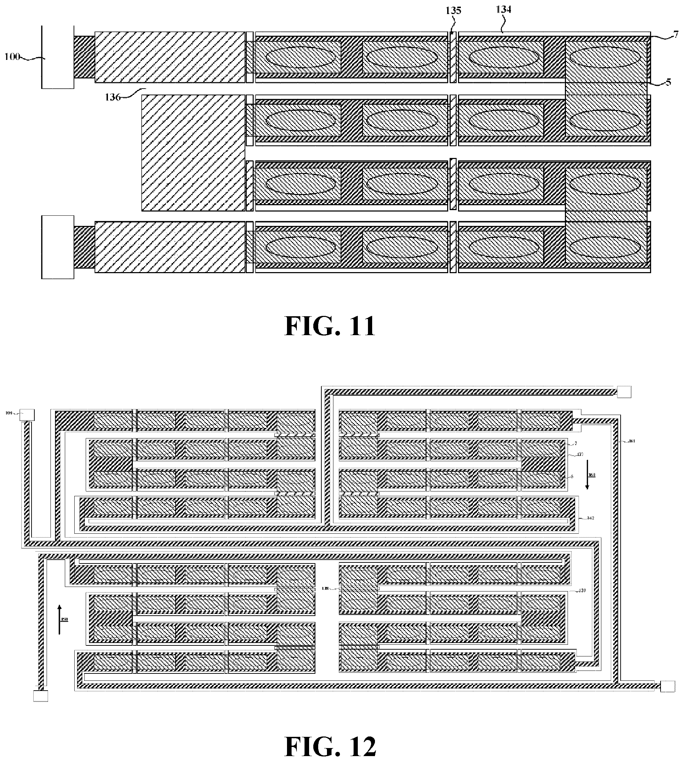

FIG. 11 is a topological diagram of the top heat absorption layer of the single-arm magnetoresistive sensor layer structure in FIG. 10. 100 is a pin, which is not covered by the top heat absorption layer 13. At this time, the top heat absorption layer above the top electrode layer 7 is 134, and the top heat absorption layer corresponding to the Region A is 135, and 134 and 135 are electrically isolated from each other. The region not covered by the electrode layer is marked as 136 and it is not covered by the heat absorption layer.

FIG. 12 is a topological diagram of the top heat absorption layer of the push-pull multi-arm magnetoresistive sensor layer structure in FIG. 10. 100 is a pin, which is not covered by the heat absorption layer. The top heat absorption layer above the top electrode layer 7 is 137. The top heat absorption layer above the bottom electrode layer 5 is 138. The top heat absorption layer connection region between the magnetoresistive sensing unit arrays is marked as 142. The top heat absorption layer region connected to the pin 100 is marked as 141, and 139 is a region not covered by the top electrode layer 7, the bottom electrode layer 5 and the top heat absorption layer 13.

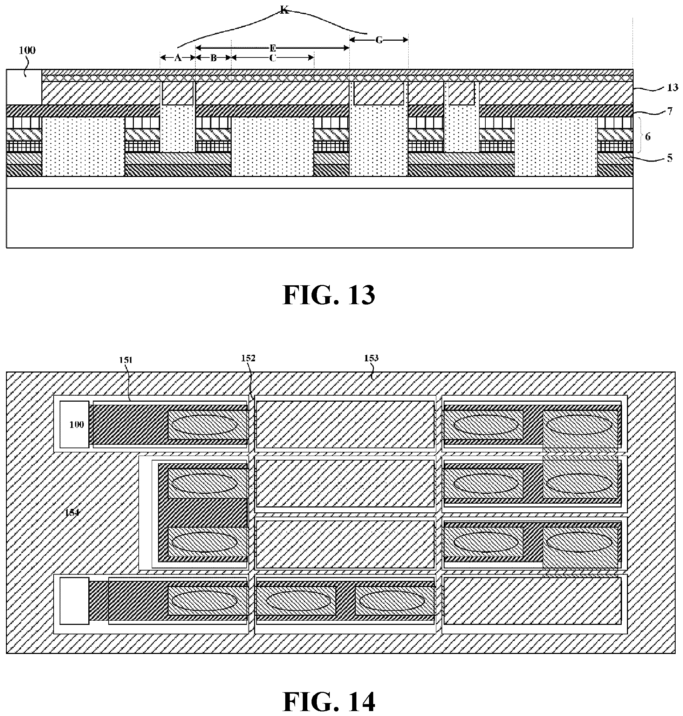

FIG. 13 is a topological diagram of the top heat absorption layer of another magnetoresistive sensor layer structure. 100 is a pin, which is not covered by a heat absorption layer. The first region of the top heat absorption layer 13 corresponds to the Region A of the magnetoresistive sensor layer structure. The second region of the top heat absorption layer 13 corresponds to the Region E of the magnetoresistive sensor layer structure. The third region of the top heat absorption layer 13 corresponds to the Region G of the magnetoresistive sensor layer structure not covered by the electrode layer. The third region is electrically isolated from the first region and the second region, respectively, or the first region and the third region, taken as a union, are electrically isolated from the second region.

FIG. 14 is a topological diagram of the top heat absorption layer of the single-arm magnetoresistive sensor layer structure in FIG. 13. 100 is a pin, which is not covered by the heat absorption layer. At this time, the top heat absorption layer above the top electrode layer 7 is 151. The top heat absorption layer above the bottom electrode layer 5 is 152. The top heat absorption layer above the region not covered by the electrode layer is 153. The top heat absorption layers 152 and 153 are combined to form a top heat absorption layer 154, and 154 and 151 are electrically isolated from each other.

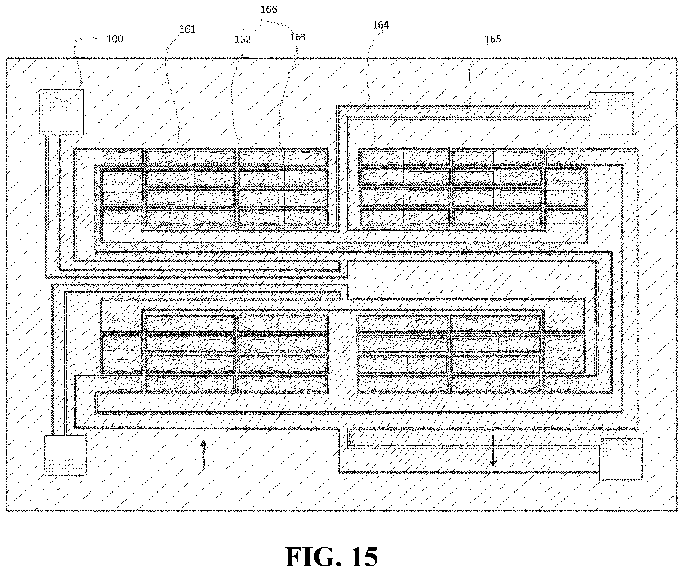

FIG. 15 is a topological diagram of the top heat absorption layer of the layer structure of push-pull multi-arm magnetoresistive sensor in FIG. 13. 100 is a pin, and there is no heat absorption layer above it. The top heat absorption layer above the top electrode layer is 161. The top heat absorption layer connection region between the magnetoresistive sensing unit arrays is marked as 164. The top heat absorption layer region connected to the pin 100 is marked as 165. The top heat absorption layer above the bottom electrode layer is 162. The top heat absorption layer corresponding to the region not covered by the electrode layer is 163. A union 166 is formed by 162 and 163, and the top heat absorption layer region 166 is electrically isolated from the top heat absorption layer region 161.

It should be noted that the above descriptions are merely preferred embodiments and technical principles of the present invention. Those skilled in the art should understand that the present invention is not limited to the specific embodiments herein, and for those skilled in the art, various obvious variations, readjustments, mutual combinations, and replacements may be made without departing from the protection scope of the present invention. Therefore, although the present invention has been described in detail with the above embodiments, the present invention is not limited to the above embodiments. Without departing from the concept of the present invention, more other equivalent embodiments may also be included, and the scope of the present invention is defined by the scope of the appended claims.

**Claims**

**1.** A layer structure of magnetoresistive sensor for laser annealing, **characterized by** comprising:

a substrate;
a magnetoresistive sensing unit, which is located on the substrate, wherein the magnetoresistive sensing unit comprises a seed layer, a bottom electrode layer, a stacking layer of magnetic sensitive units and a top electrode layer in order from bottom to top, and the stacking layer of magnetic sensitive units comprises at least an antiferromagnetic pinned layer or a permanent magnet bias layer;
a top heat absorption layer, which is located above the magnetoresistive sensing unit and/or a bottom heat absorption layer, which is located below the magnetoresistive sensing unit,
wherein the product of the volume, specific heat and density of the top heat absorption layer is greater than the product of the volume, specific heat and density of the top electrode layer,

the product of the volume, specific heat and density of the bottom heat absorption layer is greater than the product of the volume, specific heat and density of the bottom electrode layer, and

when a write temperature of the antiferromagnetic pinned layer or the permanent magnet bias layer is higher than a blocking temperature or Curie temperature respectively corresponding thereto, the temperature of the bottom electrode layer and the temperature of the top electrode layer are lower than the melting point temperatures respectively corresponding thereto;

a laser absorption layer, which is located above the magnetoresistive sensing unit;

a laser transparent layer, which is located above the laser absorption layer.

2. The magnetoresistive sensor layer structure according to claim 1, **characterized in that** a passivation layer is provided on the surface of one side of the substrate facing the magnetoresistive sensing unit, and the thermal conductivity of the passivation layer is less than 1/10 of that of the seed layer.

3. The magnetoresistive sensor layer structure according to claim 1, **characterized in that**, in the direction from bottom to top,

the top heat absorption layer covers the top electrode layer and the bottom electrode layer, and the top heat absorption layer is electrically isolated from the top electrode layer;

the top heat absorption layer comprises a first region and a second region. The first region overlaps with the bottom electrode layer and does not overlap with the top electrode layer. The second region overlaps with the top electrode layer. Insulating materials are filled between the top heat absorption layer and the top electrode layer, and the first region and the second region are in electrical contact.

4. The magnetoresistive sensor layer structure according to claim 3, **characterized in that** the top heat absorption layer also comprises a third region. The third region does not overlap with the top electrode layer and the bottom electrode layer. The third region is in electrical contact with the first region and the second region, respectively.

5. The magnetoresistive sensor layer structure according to claim 1, **characterized in that**, in the direction from bottom to top,

the top heat absorption layer covers the top electrode layer and the bottom electrode layer, and the top heat absorption layer and the top electrode layer are in electrical contact;

the top heat absorption layer comprises a first region and a second region. The first region overlaps with the bottom electrode layer and does not overlap with the top electrode layer. The second region overlaps with the top electrode layer. The first region and the second region are electrically isolated from each other.

6. The magnetoresistive sensor layer structure according to claim 5, **characterized in that** the top heat absorption layer also comprises a third region. The third region does not overlap with the top electrode layer and the bottom electrode layer, and the third region is electrically isolated from the first region and the second region, respectively.

7. The magnetoresistive sensor layer structure according to claim 1, **characterized in that**, in the direction from bottom to top,

the bottom heat absorption layer covers the top electrode layer and the bottom electrode layer, and the bottom heat absorption layer and the bottom electrode layer are electrically isolated from each other;

the bottom heat absorption layer comprises a fourth region and a fifth region. The fourth region overlaps with the bottom electrode layer and does not overlap with the top electrode layer. The fifth region overlaps with the bottom electrode layer. Insulating materials are filled between the bottom heat absorption layer and the bottom electrode layer, and the fourth region and the fifth region are in electrical contact.

8. The magnetoresistive sensor layer structure according to claim 7, **characterized in that** the bottom heat absorption layer also comprises a sixth region. The sixth region does not overlap with the top electrode layer and the bottom electrode layer, and the sixth region is in electrical contact with the fourth region and the fifth region, respectively.

9. The magnetoresistive sensor layer structure according to claim 1, **characterized in that**, in the direction from bottom to top,

the bottom heat absorption layer covers the top electrode layer and the bottom electrode layer, and the bottom heat absorption layer and the bottom electrode layer are in electrical contact;

the bottom heat absorption layer comprises a fourth region and a fifth region. The fourth region overlaps with the bottom electrode layer and does not overlap with the top electrode layer. The fifth region overlaps with the bottom electrode layer. The fourth region and the fifth region are electrically isolated from each other.

10. The magnetoresistive sensor layer structure according to claim 9, **characterized in that** the bottom heat absorption layer further comprises a sixth region. The sixth region does not overlap with the top electrode layer and the bottom electrode layer, and the sixth region is electrically isolated from the fourth region and the fifth region, respectively.

11. The magnetoresistive sensor layer structure according to claim 1, **characterized in that** the materials of the top heat absorption layer or the bottom heat absorption layer are tantalum, titanium, copper, molybdenum, gold, silver, aluminum, platinum or tin.

12. The magnetoresistive sensor layer structure according to claim 1, **characterized in that** the material of the laser absorption layer is carbon black, or a non-magnetic laser absorption resin containing carbon black, or a laser absorption paint.

13. The magnetoresistive sensor layer structure according to claim 1, **characterized in that** the materials of the laser transparent layer are $ZrO_2$, $Ti_3O_5$, $Ta_2O_6$, $HfO_2$, ZnS, ZnSe, $Al_2O_3$, MgO, $MgF_2$, $SiO_2$, $YbF_3$; or $AlF_3$.

**FIG. 1**

**FIG. 2**

**FIG. 3**

**FIG. 4**

**FIG. 5**

**FIG. 6**

**FIG. 7**

**FIG. 8**

**FIG. 9**

**FIG. 10**

**FIG. 11**

**FIG. 12**

**FIG. 13**

**FIG. 14**

**FIG. 15**

## INTERNATIONAL SEARCH REPORT

| International application No. |
| --- |
| **PCT/CN2022/137478** |

**A. CLASSIFICATION OF SUBJECT MATTER**

H10N50/10(2023.01)i

According to International Patent Classification (IPC) or to both national classification and IPC

**B. FIELDS SEARCHED**

Minimum documentation searched (classification system followed by classification symbols)

H10N50/,H01L43/

Documentation searched other than minimum documentation to the extent that such documents are included in the fields searched

Electronic data base consulted during the international search (name of data base and, where practicable, search terms used)

CNABS, CNTXT, ENTXT, ENTXTC, DWPI, CNKI: 磁, 存储, 激光, 退火, 热, magnetic, resistor, laser, annealing, heat

**C. DOCUMENTS CONSIDERED TO BE RELEVANT**

| Category* | Citation of document, with indication, where appropriate, of the relevant passages | Relevant to claim No. |
| --- | --- | --- |
| X | CN 113029208 A (JIANGSU MULTIDIMENSION TECHNOLOGY CO., LTD.) 25 June 2021 (2021-06-25) <br> description, paragraphs 75-169, and figures 2-7B | 1-2, 11-13 |
| A | CN 113029208 A (JIANGSU MULTIDIMENSION TECHNOLOGY CO., LTD.) 25 June 2021 (2021-06-25) <br> description, paragraphs 75-169, and figures 2-7B | 3-10 |
| PX | CN 114447213 A (JIANGSU MULTIDIMENSION TECHNOLOGY CO., LTD.) 06 May 2022 (2022-05-06) <br> entire document | 1-13 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **15 February 2023** | **15 February 2023** |

| Name and mailing address of the ISA/CN | Authorized officer |
| --- | --- |
| **China National Intellectual Property Administration (ISA/ CN)** <br> **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**
Information on patent family members

International application No.

**PCT/CN2022/137478**

| Patent document cited in search report | | | Publication date (day/month/year) | Patent family member(s) | Publication date (day/month/year) |
|---|---|---|---|---|---|
| CN | 113029208 | A | 25 June 2021 | None | |
| CN | 114447213 | A | 06 May 2022 | None | |

Form PCT/ISA/210 (patent family annex) (July 2022)